(19) Europäisches Patentamt
European Patent Office
Office européen des brevets

(11) Veröffentlichungsnummer: **0 039 662**
**B1**

(12) # EUROPÄISCHE PATENTSCHRIFT

(45) Veröffentlichungstag der Patentschrift: **13.02.85**

(21) Anmeldenummer: **81810166.9**

(22) Anmeldetag: **01.05.81**

(51) Int. Cl.⁴: **C 08 G 63/54**, B 01 D 13/00, C 08 G 63/52, C 08 J 5/18, G 03 C 1/68

(54) **Photohärtbare Polymere aus Succinylobernsteinsäurederivaten und Maleinsäurederivaten, Verfahren zur Herstellung der Polymeren und ihre Verwendung.**

(30) Priorität: **07.05.80 CH 3553/80**

(43) Veröffentlichungstag der Anmeldung: **11.11.81 Patentblatt 81/45**

(45) Bekanntmachung des Hinweises auf die Patenterteilung: **13.02.85 Patentblatt 85/7**

(84) Benannte Vertragsstaaten: **CH DE FR GB IT LI NL**

(56) Entgegenhaltungen:
**DE - A - 2 906 334**
**US - A - 3 776 737**

**DIE MAKROMOLEKULARE CHEMIE Band 13, Nr. 2/3, Oktober 1954 Heidelberg H. HOLTSCHMIDT "Über Esterkondensationen an Polyestern und die Herstellung reaktionsfähiger Polyester" Seiten 141 bis 170**
**Chemical Abstracts Band 82, Nr. 18 5. Mai 1975 Columbus, Ohio, USA M. OHKAWA et al. "Polyester" Seite 82, Spalte 1, Abstract Nr. 113282e**

(73) Patentinhaber: **CIBA-GEIGY AG, Postfach, CH-4002 Basel (CH)**

(72) Erfinder: **Batzer, Hans, Dr. Prof., Rainweg 7, CH-4144 Arlesheim (CH)**
Erfinder: **Sinnreich, Joel, Dr., Karlstrasse 9, D-6140 Bensheim/Bergstrasse (DE)**

**EP 0 039 662 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft neue, photohärtbare Polymere aus Succinylobernsteinsäuredi-(hydroxyalkylester) oder -di(-hydroxycycloalkylestern) und Maleinsäurederivaten, Verfahren zu deren Herstellung und die Verwendung der photovernetzbaren Polymeren, insbesondere als Photoresist, oder zum Erzeugen von lösungsmittelbeständigen semipermeablen Membranen.

Polymere auf Basis von Succinylobernsteinsäureestern sind bekannt, z. B. Makromolekulare Chemie XIII, 157 (1954). Photovernetzbare Polymere hingegen auf Basis von Succinylobernsteinsäureestern sind bisher nicht beschrieben worden. Aus »Helvetica Chimica Acta«, Volumen 56, 1973, Seite 2760—2765, und aus der DE-OS 2 437 875 ist lediglich bekannt geworden, daß man durch Bestrahlen von Succinylobernsteinsäure oder einem Dialkylester davon mit UV-Licht oder mit $\gamma$-Strahlung die Dimeren dieser Verbindungen erhält, wenn man die Monomeren im kristallinen Zustand bestrahlt. Die auf diese Weise erhaltenen Dimeren finden Verwendung zur Herstellung von linearen Polyestern, die chelatbildende und fadenbildende Eigenschaften aufweisen.

Es wurde nun gefunden, daß man durch Umsetzung von Bis-(hydroxyalkyl)- oder Bis-(hydroxycycloalkyl)-succinylobernsteinsäureestern mit Maleinsäurederivaten lineare Polymere erhält, die sich durch Photohärtung in den vernetzten Zustand überführen lassen.

Gegenstand der vorliegenden Erfindung sind somit ungesättigte, photovernetzbare Polymere mit einer relativen Viskosität von 1,05 bis 2,5, gemessen an Lösungen von 1 g Polymer in 100 ml eines aus gleichen Teilen Phenol und o-Dichlorbenzol bestehenden Lösungsmittels bei 30°C, bestehend im wesentlichen aus dem wiederkehrenden Strukturelement der Formel I

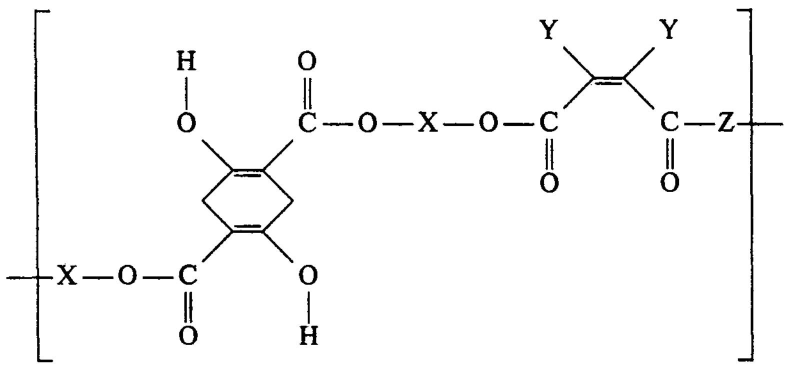

(I)

worin X ein linearen oder verzweigtes Alkylen mit 2 bis 10 C-Atomen, einen cycloaliphatischen oder cycloaliphatisch-aliphatischen Rest mit bis zu 15 C-Atomen bedeutet, beide Y unabhängig voneinander je ein Wasserstoffatom oder Methyl bedeuten und Z für —O—, —NH— oder

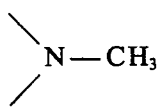

steht.

Vorzugsweise bedeutet in Formel I X ein Alkylen mit 2 bis 10 C-Atomen. Ferner stehen beide Y bevorzugt je für ein Wasserstoffatom und Z steht bevorzugt für ein Sauerstoffatom.

Insbesondere betrifft die vorliegende Erfindung Polyester mit dem wiederkehrenden Strukturelement der Formel I, worin X ein Alkylen mit 2 bis 10 C-Atomen bedeutet, beide Y je für ein Wasserstoffatom und Z für ein Sauerstoffatom stehen.

Die Polymeren mit dem wiederkehrenden Strukturelement der Formel I können hergestellt werden, indem man ein hydroxylgruppenhaltiges Succinylobernsteinsäurederivat der Formel II

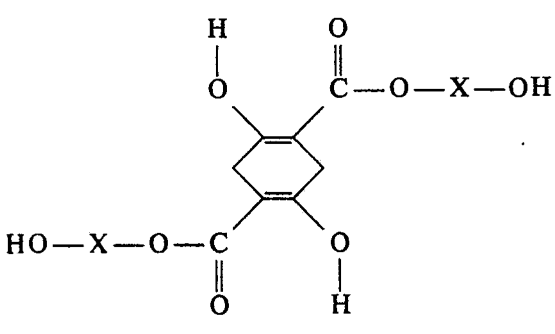

(II)

worin X die gleiche Bedeutung wie in Formel I hat, mit einem Maleinsäurederivat der Formel III

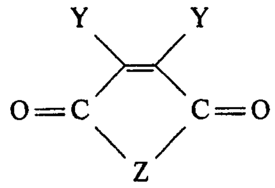

(III)

worin Y und Z die gleiche Bedeutung wie in Formel I haben, in einem Molverhältnis von 1 : 1 bis 1 : 2 in der Schmelze oder in einem inerten Lösungsmittel, vorzugsweise in der Schmelze, bis zu einer relativen Viskosität von 1,05 bis 2,5, vorzugsweise unter milden Bedingungen, polykondensiert.

Vorzugsweise verwendet man zur Herstellung der Polymeren mit dem Strukturelement der Formel I Succinylobernsteinsäurederivate der Formel II, worin X ein Alkylen mit 2 bis 10 C-Atomen darstellt. Als bevorzugte Verbindung der Formel III verwendet man Maleinsäureanhydrid.

Die Succinylobernsteinsäurederivate der Formel II und die Maleinsäurederivate der Formel III sind bekannt. Die Succinylobernsteinsäurederivate können zum Beispiel nach dem in »Helvetica Chemica Acta«, Volumen 62, 1979, Seite 1682—1687, beschriebenen Verfahren durch Umesterung von Diäthylsuccinylsuccinat (Succinylobernsteinsäurediäthylester) mit den Na-Alkoholaten der Alkandiole, der cycloaliphatischen oder cycloaliphatisch-aliphatischen Diole hergestellt werden. In der genannten Literaturstelle wird beispielsweise die Herstellung folgender Succinylsuccinatderivate der Formel II beschrieben:

Bis-(2-hydroxyäthyl)-succinylsuccinat,
Bis-(3-hydroxypropyl)-succinylsuccinat,
Bis-(4-hydroxybutyl)-succinylsuccinat,
Bis-(2,2-dimethyl-3-hydroxypropyl)-succinylsuccinat,
Bis-(6-hydroxyhexyl)-succinylsuccinat,
Bis-(4-hydroxycyclohexyl)-succinylsuccinat und
Bis-[4-(hydroxymethyl)-cyclohexylmethyl]-succinylsuccinat.

Als Alkandiole zur Herstellung von Verbindungen der Formel II können solche mit linearem oder verzweigtem Kohlenwasserstoffrest eingesetzt werden. Als geeignete Alkandiole seien beispielsweise genannt: Äthylenglykol, 1,2- oder 1,3-Propylenglykol, 1,3-, 2,3- oder 1,4-Butandiol, Neopentylglykol, 1,6-Hexandiol und 1,10-Decandiol.

Geeignete cycloaliphatische Diole sind beispielsweise 1,4-Dihydroxycyclohexan, hydriertes Bisphenol A (2,2-Bis-(p-hydroxycyclohexyl)-propan) und hydriertes Bisphenol F (Bis-(p-hydroxycyclohexyl)-methan). Ein geeignetes cycloaliphatisch-aliphatisches Diol ist beispielsweise 1,4-(Dihydroxymethyl)-cyclohexan.

Wie eingangs erwähnt, können die erfindungsgemäßen, linearen Polymeren durch Photoerhärtung in den vernetzten Zustand überführt werden, wobei die Photohärtung ohne Abspaltung kleiner Moleküle verläuft und somit nicht mit Blasenbildung auf dem vernetzten Polymer verbunden ist.

Die erfindungsgemäßen Polymeren zeichnen sich durch eine hohe UV-Absorption bei Wellenlängen von $\lambda < 300$ nm aus und können mit kurzwelligem UV-Licht ohne Zusatz von Photosensibilisatoren vernetzt werden. Im langwelligen UV-Bereich, d. h., bei Wellenlängen von $\lambda > 300$ nm sind die erfindungsgemäßen Polymeren stabil. Zu ihrer Vernetzung in diesem Wellenlängenbereich sind daher Photosensibilisatoren erforderlich. Es ist auch möglich, die erfindungsgemäßen Polymeren mittels $\gamma$-Strahlung oder beschleunigten Elektronen zu vernetzen.

Die erfindungsgemäßen Polymeren eignen sich beispielsweise zur Herstellung von Druckplatten für das Offsetdruckverfahren, zur Herstellung von Photooffsetlacken und insbesondere als Photoresists zur Herstellung von gedruckten Schaltungen nach an sich bekannten Methoden. Dabei wird die mit der lichtempfindlichen Schicht versehene Seite der Leiterplatte durch ein das Leiterbild aufweisendes Dianegativ belichtet und dann entwickelt, wobei man die unbelichteten Stellen der Schicht durch Entwicklungsflüssigkeit herauslöst. Die Belichtung kann mit Sonnenlicht, Kohlelichtbogen oder Xenonlampen durchgeführt werden. Mit Vorteil wird die Belichtung mit Quecksilberhochdrucklampen vorgenommen. Die Trägermaterialien können nach an sich üblichen Techniken mit den lichtempfindlichen Polymeren beschichtet werden, z. B. durch Tauchverfahren, Sprüh-, Schleuder-, Kaskaden- oder Vorhangguß oder sogenannten »roller-coating«. Die erhaltenen Polymeren weisen einen fluoreszierendes Effekt auf und haben dadurch den Vorteil, daß sich eine Anfärbung zu ihrer Erkennbarmachung erübrigt.

Die aus den erfindungsgemäßen Polymeren durch Photovernetzung erhaltenen Filme sind lösungsmittelbeständig und metallchelatisierend, was sie als aktive Schicht für selektiven Stofftransport in semipermeablen Membranen befähigt und somit für die Verwendung als Membranen für die Umkehrosmose geeignet macht. Durch das Chelatisierungsvermögen der vernetzten Polymeren kann auf den Membranen eine stationäre Oberflächenpolarisation erzielt werden, die sich besonders vorteilhaft auf

eine Erhöhung der Trennwirksamkeit bei der Umkehrosmose auswirkt. Hierbei kann durch die nachträgliche Erzeugung der Oberflächenpolarisation eine Abstimmung auf das jeweilige Trennproblem vorgenommen werden. Die gewünschte Polarisation kann auch direkt während der Umkehrosmose durch gelöste Metallsalze erzeugt werden. Mit der Polarisation wird im wesentlichen eine Erhöhung des Rückhaltevermögens von im zu reinigenden Wasser gelösten Metallsalzen erreicht.

Die aus den vernetzten Polymeren bestehenden Filme können direkt oder verstärkt durch eine poröse Stützstruktur als Membranen eingesetzt werden.

Gegenstand vorliegender Erfindung ist somit auch die Verwendung der erfindungsgemäßen, photovernetzbaren Polymeren mit dem wiederkehrenden Strukturelement der Formel I als Photoresists oder zur Herstellung von Membranen, die insbesondere für die Umkehrosmose geeignet sind.

Beispiel 1—6

Bis-(2-hydroxyäthyl)-succinylsuccinat ($SBC_2$) oder Bis-(6-hydroxyhexyl)-succinylsuccinat ($SBC_6$) wird mit Maleinsäureanhydrid (MA) in dem in Tabelle 1 angegebenen Molverhältnis gemischt und in bekannter Weise verestert und polykondensiert. Die Veresterungs- bzw. Polykondensationsbedingungen sind ebenfalls in Tabelle 1 angegeben. Die Ausbeute und die Eigenschaften der erhaltenen Polyester sind in Tabelle 1 aufgeführt.

Die relative Viskosität wurde an einer Lösung von 1 g Polyester in 100 ml eines aus gleichen Teilen Phenol und o-Dichlorbenzol bestehenden Lösungsmittels bei 30° C gemessen.

Tabelle 1

Polyester aus Bis-(2-hydroxyäthyl)-succinylsuccinat ($SBC_2$) oder Bis-(6-hydroxyhexyl)-succinylsuccinat ($SBC_6$) und Maleinsäureanhydrid

| Beispiel | $SBC_2$ (g) | MA (g) | Molverhältnis | Veresterung Zeit/Temperatur (Std./°C) | Polykondensation Zeit/Temperatur (Std./°C) | Ausbeute (g) | (% d. Th.) | rel. Viskosität η rel. | Schmelzpunkt (°C) | Glasumwandlungstemperatur (°C) |
|---|---|---|---|---|---|---|---|---|---|---|
| 1 | 115,2 | 39,2 | 1 : 1 | 9/160 | 2/160 | 93 | 63 | 1,09 | 106 | 50 |
| 2 | 8,64 | 4,41 | 1 : 1,5 | 4/150 | 8,5/150—175 | 6,8 | 62 | 1,07 | 125 | 57 |
| 3 | 8,64 | 5,88 | 1 : 2 | 4/150 | 4,25/150 | 7,5 | 68 | 1,06 | 92 | 56 |
| | $SBC_6$ (g) | MA (g) | | | | | | | | |
| 4 | 12,0 | 2,94 | 1 : 1 | 6/140—180 | 1/140—150 | | | 1,14 | 117 | —8 |
| 5 | 8,0 | 2,94 | 1 : 1,5 | 3,5/150 | 0,5/150 | 8,0 | 83 | 1,18 | 131 | —4 |
| 6 | 8,0 | 3,92 | 1 : 2 | 4/160 | 0,5/150 | 8,3 | 86 | 1,23 | 147 | —6 |
| 7 | 8,0 | 2,94 | 1 : 1,5 | 2,75/150—160 | 0,75/150 | 7,8 | 81 | 1,19 | 122 | —8 |
| 8 | 80 | 39,2 | 1 : 2 | 3,5/150 | 0,33/150 | 90 | 94 | 1,20 | 138 | —2 |

Applikationsbeispiele

Beispiel I

Aus dem gemäß Beispiel 1 erhaltenen Polyester und Methylenchlorid wird eine 10gew.-%ige Lösung hergestellt, die auf Aluminiumbleche aufgetragen wird. Die so erhaltenen Beschichtungen werden an der Luft getrocknet und zum Teil mit Aluminiumfolien abgedeckt. Dann werden die Beschichtungen mit ungefiltertem UV-Licht ($\lambda > 200$ nm) unterschiedlich lang während 1 bis 360 Minuten bestrahlt, wobei Beschichtungen erhalten werden, die sich bezüglich ihres Aussehens von den bestrahlten und nichtbestrahlten Teilen nicht unterscheiden. Dann werden die beschichteten Aluminiumbleche während 3 Minuten in Tetrahydrofuran eingetaucht, wobei sowohl die unbestrahlten Teile der Beschichtungen als auch die nur bis zu 4 Minuten bestrahlten Beschichtungen sich auflösen.

Die länger als 4 Minuten bestrahlten Beschichtungen ergeben einheitlichen, fluoreszierende Filme auf dem Metall.

Beispiel II

Aus dem gemäß Beispiel 6 hergestellten Polyester wird ein 25 µm dicker Film hergestellt, der mit kurzwelligem UV-Licht ($\lambda > 200$ nm) mittels einer Quecksilberlampe (Typ »Hanau, TQ 150«) aus einer Distanz von 30 cm während 4 Stunden bestrahlt wird, wobei ein in Aceton unlöslicher Film erhalten wird. Dieser Film wird als Membran in einem Hyperfiltrationstest eingesetzt. Bei einem Druck von 100 bar beträgt der Wasserdurchfluß 0,13 Liter/m$^2$d, was einem Wasserdurchfluß von 32,5 Liter/m$^2$d für eine 0,1 µm dicke Membrane entspricht.

Bei Verwendung einer 0,1 N wäßrigen NaCl-Lösung wird unter gleichen Versuchsbedingungen ein Wasserdurchfluß von 0,73 Liter/m$^2$d gemessen, was einem Wasserdurchfluß von 182,5 Liter/m$^2$d für eine 0,1 µm dicke Membrane entspricht. Der Salzrückhalt beträgt 97,8%.

**Patentansprüche**

1. Ungesättigtes, photovernetzbares Polymer mit einer relativen Viskosität von 1,05 bis 2,5, gemessen an Lösungen von 1 g Polymer in 100 ml eines aus gleichen Teilen Phenol und o-Dichlorbenzol bestehenden Lösungsmittels bei 30° C, bestehend im wesentlichen aus dem wiederkehrenden Strukturelement der Formel I

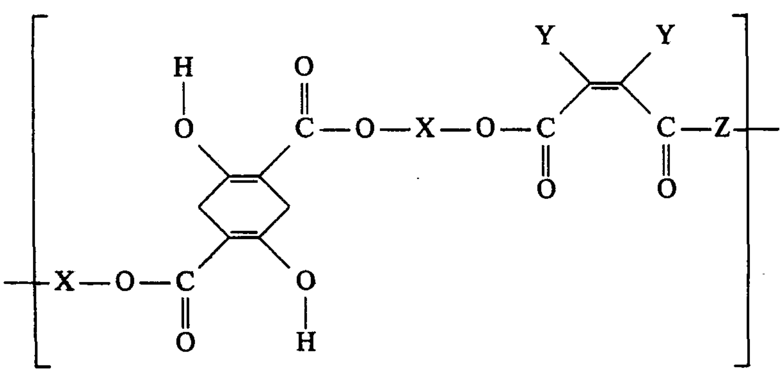

(I)

worin X ein lineares oder verzweigtes Alkylen mit 2 bis 10 C-Atomen, einen cycloaliphatischen oder cycloaliphatisch-aliphatischen Rest mit bis zu 15 C-Atomen bedeutet, beide Y unabhängig voneinander je ein Wasserstoffatom oder Methyl bedeuten und Z für —O—, —NH— oder

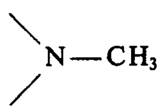

steht.

2. Polymer gemäß Anspruch 1, worin im wiederkehrenden Strukturelement der Formel I X ein Alkylen mit 2 bis 10 C-Atomen bedeutet.

3. Polymer gemäß Anspruch 1, worin im wiederkehrenden Strukturelement der Formel I beide Y je für ein Wasserstoffatom und Z für ein Sauerstoffatom stehen.

4. Polymer gemäß Anspruch 1, worin im wiederkehrenden Strukturelement der Formel I X ein Alkylen mit 2 bis 10 C-Atomen bedeutet, beide Y je für ein Wasserstoffatom und Z für ein Sauerstoffatom stehen.

5. Verfahren zur Herstellung von Polymeren gemäß Anspruch 1, dadurch gekennzeichnet, daß man ein hydroxylgruppenhaltiges Succinylobernsteinsäurederivat der Formel II

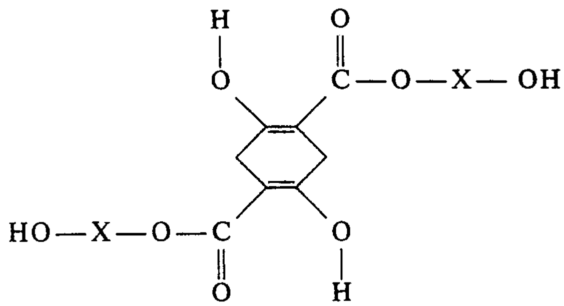

(II)

worin X die gleiche Bedeutung wie in Formel I hat, mit einem Maleinsäurederivat der Formel III

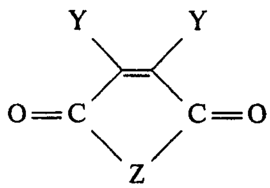

(III)

worin Y und Z die gleiche Bedeutung wie in Formel I haben, in einem Molverhältnis von 1 : 1 bis 1 : 2 in der Schmelze oder in einem inerten Lösungsmittel bis zu einer relativen Viskosität von 1,05 bis 2,5, gemessen an Lösungen von 1 g Polymer in 100 ml eines aus gleichen Teilen Phenol und o-Dichlorbenzol bestehenden Lösungsmittels bei 30° C, polykondensiert.

6. Verfahren gemäß Anspruch 5, dadurch gekennzeichnet, daß man ein Succinylobernsteinsäurederivat der Formel II verwendet, worin X ein Alkylen mit 2 bis 10 C-Atomen bedeutet.

7. Verfahren gemäß Anspruch 5 oder 6, dadurch gekennzeichnet, daß man als Maleinsäurederivat der Formel III Maleinsäureanhydrid verwendet.

8. Verwendung der photovernetzbaren Polymeren mit dem wiederkehrenden Strukturelement der Formel I gemäß Anspruch 1 als Photoresist.

9. Verwendung der photovernetzbaren Polymeren mit dem wiederkehrenden Strukturelement der Formel I gemäß Anspruch 1 zur Herstellung von lösungsmittelbeständigen Membranen für die Umkehrosmose.

**Claims**

1. An unsaturated, photo-crosslinkable polymer having a relative viscosity of 1.05 to 2.5, measured on a solution of 1 g of polymer in 100 ml of a solvent, consisting of equal parts of phenol and o-dichlorobenzene, at 30° C, which polymer consists essentially of recurring structural units of the formula I

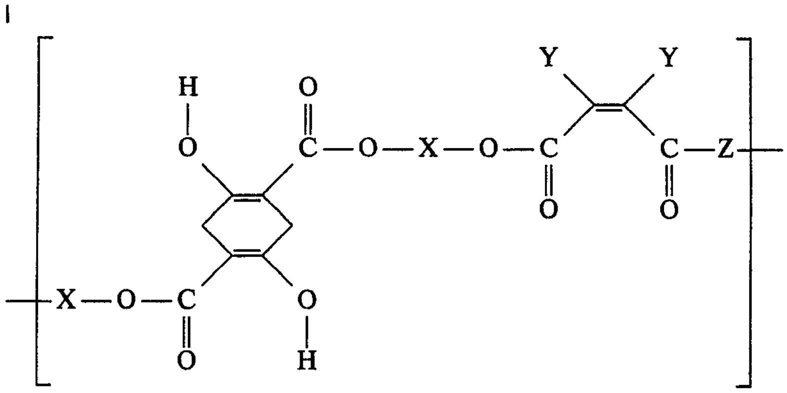

(I)

in which X is linear or branched alkylene having 2 to 10 C atoms or a cycloaliphatic or cycloaliphatic-aliphatic radical having up to 15 C atoms, the two Y, independently of one another, are each a hydrogen atom or methyl, and Z is —O—, —NH— or

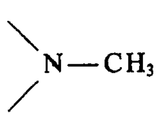

2. A polymer according to claim 1, in which, in the recurring structural unit of the formula I, X is alkylene having 2 to 10 C atoms.

3. A polymer according to claim 1, in which, in the recurring structural unit of the formula I, both Y are a hydrogen atom and Z is an oxygen atom.

4. A polymer according to claim 1, in which, in the recurring structural unit of the formula I, X is alkylene having 2 to 10 C atoms, both Y are a hydrogen atom and Z is an oxygen atom.

5. A process for the preparation of a polymer according to claim 1, which comprises polycondensing a succinylosuccinic acid derivative, containing hydroxyl groups, of the formula II

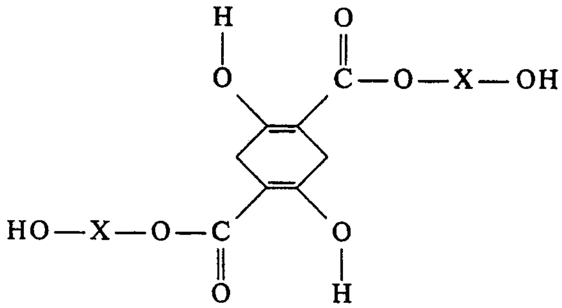

(II)

in which Y is defined as for formula I, with a maleic acid derivative of the formula III

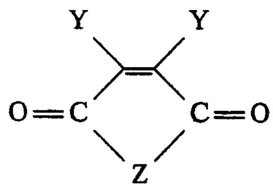

(III)

in which Y and Z are as defined for formula I, in a molar ratio of 1 : 1 to 1 : 2, as a melt or in an inert solvent, until the product has a relative viscosity of 1.05 to 2.5, measured on a solution of 1 g of polymer in 100 ml of a solvent, consisting of equal parts of phenol and o-dichlorobenzene, at 30° C.

6. A process according to claim 5, wherein a succinylosuccinic acid derivative of the formula II, in which X is alkylene having 2 to 10 C atoms, is used.

7. A process according to claim 5 or 6, in which maleic anhydride is used as the maleic acid derivative of the formula III.

8. Use of a photo-crosslinkable polymer having recurring structural units of the formula I, according to claim 1, as a photoresist.

9. Use of o photo-crosslinkable polymer having recurring structural units of the formula I, according to claim 1, for the preparation of a solvent-resistant membrane for reverse osmosis.

**Revendications**

1. Polymère insaturé, photoréticulable, ayant une viscosité relative, mesurée à 30° C sur des solutions de 1 g de polymère dans 100 ml d'un solvant constitué de parties égales de phénol et d'o-dichlorobenzène, de 1,05 à 2,5, constitué essentiellement du motif structural répondant à la formule I:

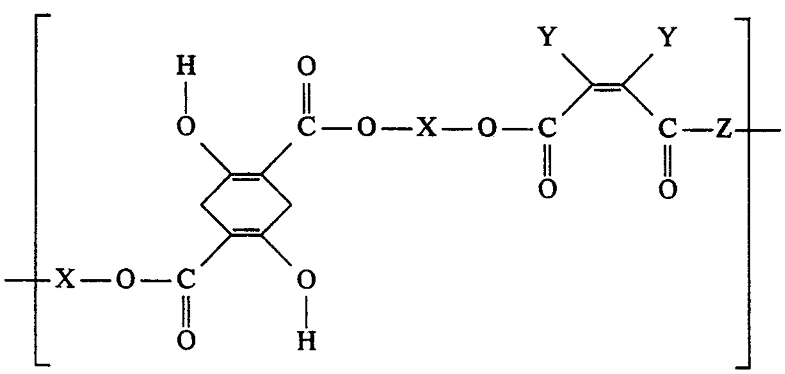

(I)

dans laquelle X désigne un alkylène linéaire ou ramifié en $C_2$ à $C_{10}$, un radical cycloaliphatique ou cycloaliphatique-aliphatique ayant jusqu'à 15 atomes de carbone, les deux Y désignant indépendamment l'un de l'autre chacun un hydrogène ou un méthyle, et Z désignant —O—, —NH— ou

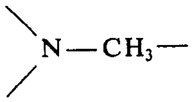

2. Polymère suivant la revendication 1, dans lequel dans le motif structural répondant à la formule I, X désigne un alkylène en $C_2$ à $C_{10}$.

3. Polymère suivant la revendication 1, dans lequel dans le motif structural répondant à la formule I, les deux Y désignent chacun un atome d'hydrogène et Z un atome d'oxygène.

4. Polymère suivant la revendication 1, dans lequel dans le motif structural répondant à la formule I, X désigne un alkylène en $C_2$ à $C_{10}$, les deux Y désignent chacun un atome d'hydrogène et Z un atome d'oxygène.

5. Procédé de préparation de polymères suivant la revendication 1, caractérisé en ce qu'on polycondense à 30°C un dérivé de l'acide succinylsuccinique contenant des groupes hydroxyles répondant à la formule II:

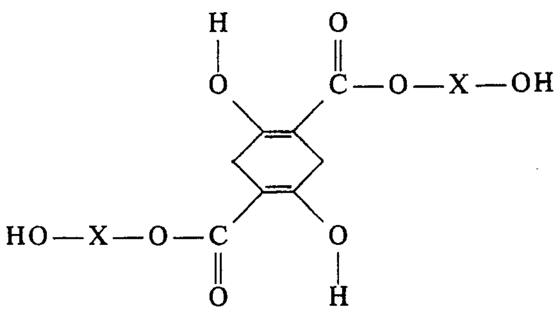

(II)

dans laquelle X à la même signification que dans la formule I, avec un dérivé de l'acide maléique répondant à la formule III:

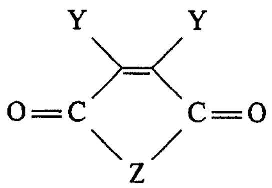

(III)

dans laquelle Y et Z ont la même signification que dans la formule I, dans un rapport molaire de 1 : 1 à 1 : 2, à l'état fondu ou dans un solvant inerte, jusqu'à une viscosité relative, mesurée sur des solutions de 1 g de polymère dans 100 ml d'un solvant constitué de parties égales de phénol et d'o-dichlorobenzène, de 1,05 à 2,5.

6. Procédé suivant la revendication 5, caractérisé en ce qu'on utilise un dérivé de l'acide succinylsuccinique répondant à la formule II, dans laquelle X désigne un alkylène en $C_2$ à $C_{10}$.

7. Procédé suivant l'une quelconque des revendications 5 ou 6, caractérisé en ce qu'on utilise comme dérivé de l'acide maléique répondant à la formule III de l'anhydride maléique.

8. Utilisation des polymères photoréticulables ayant le motif structural répondant à la formule I suivant la revendication 1 comme photoresist.

9. Utilisation des polymères photoréticulables avec le motif structural répondant à la formule I suivant la revendication 1 pour la fabrication de membranes résistant aux solvants pour l'osmose inverse.